# EUROPEAN PATENT SPECIFICATION

(11) **EP 0 299 723 B1**
(45) Date of publication and mention of the grant of the patent: **15.09.1993**
(21) Application number: 88306363.8
(22) Date of filing: 12.07.1988
(51) Int. Cl.: G05F 3/26

(54) **Current mirror circuit**
Stromspiegelschaltung
Circuit miroir de courant

(30) Priority: 17.07.1987 JP 177274/87
(43) Date of publication of application: 18.01.1989
(73) Proprietor: KABUSHIKI KAISHA TOSHIBA, Kawasaki-shi, Kanagawa-ken 210 (JP)
(72) Inventor: Nishio, Koji c/o Patent Division, Minato-ku Tokyo (JP)
(74) Representative: Freed, Arthur Woolf

(56) References cited:
- EP-A- 0 067 447
- EP-A- 0 108 428
- US-A- 4 329 639
- US-A- 4 591 780
- IBM TECHNICAL DISCLOSURE BULLETIN, vol. 29, no. 3, August 1986, pages 1116-1117, New York, US: "Compensated precision cascode source"

## Description

### BACKGROUND OF THE INVENTION

### Field of the Invention

This invention concerns a current mirror circuit. More particularly, this invention concerns a current mirror circuit which is operative at a relatively low power source voltage.

### Description of the Prior Art

A current mirror circuit is widely used as a basic circuit, such as a constant current source for a bias circuit, or as a current distribution circuit in a analogue circuit, as well as an amplifier circuit.

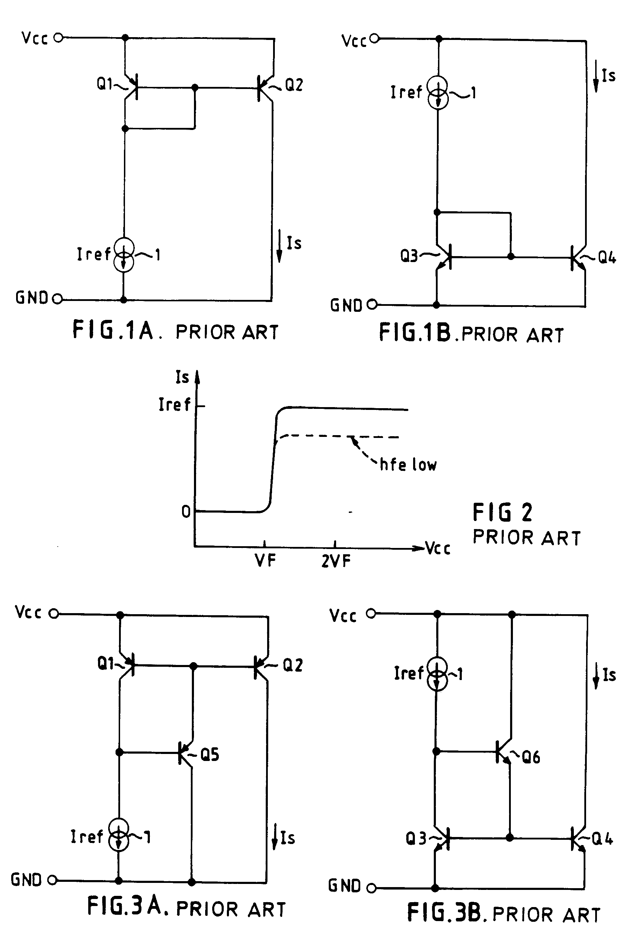

**FIG.1A** and **FIG.1B** are circuit diagrams of basic current mirror circuits.

In **FIG.1A**, the emitter electrodes of **PNP** transistors **Q1** and **Q2** are connected to a power source terminal **Vcc**, and the base electrodes thereof are connected in common. The common connection of the base electrodes of the transistors **Q1** and **Q2** is connected to a ground terminal **GND** through an input current source **1**. The collector electrode of the transistor **Q2** is connected to the **GND** terminal.

In this circuit, when the transistors **Q1** and **Q2** have same geometric dimension, the collector current **Is** of the transistor **Q2** is equal to the input current Iref, assuming that the base currents of the transistor **Q1** and **Q2** are negligible with respect to the collector currents of the transistors **Q1** and **Q2**. This current mirror circuit is operative at a power source voltage which is higher than the base-emitter voltage VF of the transistor **Q1** and **Q2**.

However, in this circuit, as the base currents of the transistors **Q1** and **Q2** are added to the collector current of the transistor **Q1**, this causes an error in the current mirror ratio between the input current Iref and the collector current Is of the transistor **Q2**. Namely, the relationship between the input current and the output current Is is expressed as follows:

${\text{Is=Iref/(1+2/h}}_{\text{FE}} \text{) (1)}$

wherein h_{FE} is the current gain of the transistors **Q1** and **Q2**. Assuming that the h_{FE} is 10, the output curent Is is approximately about 0.83.Iref from equation (1). This error is notable when the current gains of the transistors **Q1** and **Q2** are low. Thus, the collector current Is of the transistor **Q2** decreases compared with the input current Iref, as shown in **FIG.2** as a dotted line, when the current gain is low.

In **FIG.1B**, **NPN** transistors are used instead ot the **PNP** transistors in the circuit of **FIG.1A**. The common base connection of the transistors **Q3** and **Q4** is connected to the collector electrode of the transistor **Q3** in the same way as in **FIG.1A**. Thus, the same problem exists in this circuit.

To solve the above problem, improved current mirror circuits as shown in **FIGS.3A** and **3B** have been used.

In the circuit of **FIG.3A**, a compensating transistor **Q5** of **PNP** type is provided. Namely, the emitter electrode of the transistor **Q5** is connected to the common connection of the base electrodes of the transistors **Q1** and **Q2**. The base electrode of the transistor **Q5** is connected to the collector electrode of the transistor **Q1**, and the collector electrode thereof is connected to the **GND** terminal.

In this circuit, the current to be added to the collector current of the transistor**Q1** is reduced to 1/h _{FE} of the base currents of the transistors **Q1** and **Q2** (h_{FE} is the current gain of the transistor **Q5**). The relationship between the output current Is and the input current Iref can be expressed as follows: 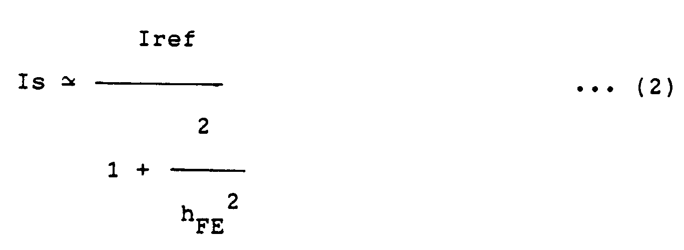
Assuming that the h_{FE} is 10, the Is is approximately 0.98.Iref. Thus, the error of the current mirror ratio due to the base current is improved.

In the same way, the current mirror circuit of **FIG.3B** is provided with a compensating transistor **Q6** of **NPN** type to improve the current mirror ratio thereof.

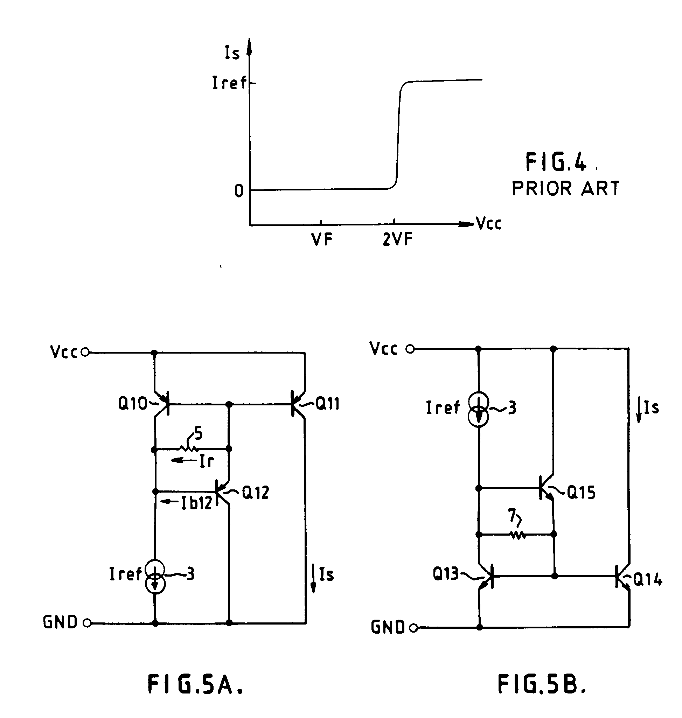

However, in these current mirror circuits, it is necessary to increase the power source voltage higher than 2VF to operate the circuits. Thus, the minimum power source voltage to operate the current mirror circuit is increased to 2VF as shown in **FIG.4**.

### SUMMARY OF THE INVENTION

Therefore, an object of this invention is to provide a current mirror circuit having a smaller error of the current mirror ratio, and which operates at a relatively low power source voltage.

To achieve the object, this invention provides a current mirror circuit which comprises: first and second power source terminals; first transistor means for receiving an input current, having an emitter electrode, a base electrode and a collector electrode: second transistor means for outputting an output current, having an emitter electrode, a base electrode and a collector electrode; means for connecting the emitter electrodes of said first and second transistor means to the first power source terminal; resistor means for connecting the base electrode of the first transistor means to the collector electrode thereof; third transistor means for supplying a predetermined current to the base electrodes of the first and second transistor means when the voltage drop across the resistor means exceeds a predetermined value; and means for supplying the input current to the collector electrode of the first transistor means.

### BRIEF DESCRIPTION OF THE DRAWINGS

The accompanying drawings, which are incorporated in and constitute a part of the specification, illustrate an embodiment of the invention, and, together with the description, serve to explain the principles of the invention. Referring now to the drawings, like reference characters designate like or corresponding parts throughout the several views. Of the drawings:
**FIG.1A** and **FIG.1B** are circuit diagrams of conventional current mirror circuits.
**FIG.2** is a diagram showing characteristics of the prior art.
**FIG.3A** and **FIG.3B** are circuit diagrams of other conventional current mirror circuits.
**FIG.4** is a diagram showing the characteristics of the prior art of **FIG.3A** and **3B**.
**FIG.5A** and **FIG.5B** are circuit diagrams of current mirror circuits of this invention.
**FIG.6** is a diagram showing the characteristics of the embodiment of **FIGS.5A** and **5B**.
**FIG.7** is a circuit diagram of an amplifier circuit provided with the improved current mirror circuit of this invention.

### DETAILED DESCRIPTION OF THE INVENTION

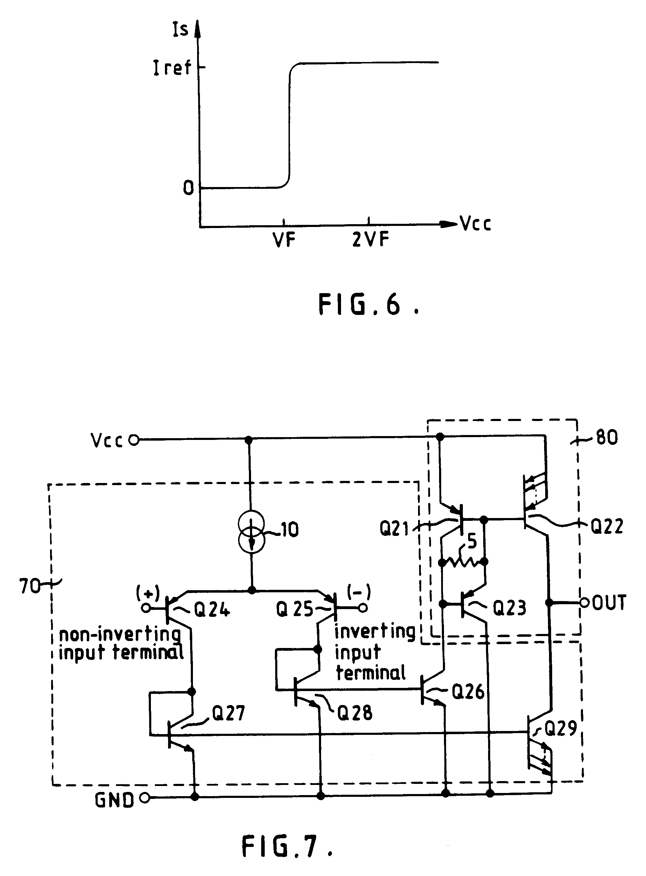

**FIG.5A** is a circuit diagram of current mirror circuit of this invention. In **FIG.5A**, the emitter electrodes of the **PNP** transistors **Q10** and **Q11** are connected to the power source terminal **Vcc**. The base electrodes of the transistors **Q10** and **Q12** are connected in common. The collector electrode of the transistor **Q10** is connected to the **GND** terminal through an input current source **3**. The emitter electrode of a base compensating transistor **Q12** of **PNP** type is connected to the common connection of the base electrodes of the transistors **Q10** and **Q11**. The base electrode of the transistor **Q12** is connected to the collector electrode of the transistor **Q10**, and the collector electrode of the transistor **Q12** is connected to the **GND** terminal. A resistor **5** is connected between the base and the collector electrodes of the transistor **Q10**.

In this circuit, when the power source voltage Vcc is below VF (VF corresponds to the base to emitter voltage of the transistors **Q10**, **Q11** and **Q12**), no transistor is in a conductive state. When the power source voltage Vcc exceeds VF, assuming the voltage drop at the input current source 3 is negligible, a base current is supplied to the common connection of the base electrode of the transistors **Q10** and **Q11** through the resistor **5**. Thus, the transistors **Q10** and **Q11** change into a conductive state. This circuit is operative when the following relationship is satisfied:

$\text{2Ib·R < Vcc - VF (3)}$

wherein Ib is the base current of the transistors **Q10** and **Q11**, and R is the resistance value of the resistor **5**. Therefore, even if the power source voltage Vcc is below 2·VF, this circuit is operative as a current mirror circuit.

When the power source voltage Vcc increases, and the voltage drop at the resistor **5** exceeds VF, the transistor **Q12** changes into a conductive state. In this state, the current Ir which flows through the resistor **5** and the base current Ib12 of the transistor **Q12** cause the error in the current mirror ratio. As the voltage drop at the resistor **5** is limited to VF (the base to emitter voltage of the transistor **Q12**) by the transistor **Q12**, even if the power source voltage is increased, a current to be added to the collector current of the transistor **Q12** through the resistor **5** is limited. In the case where the resistance value of the resistor **5** is 30 KΩ, the current Ir which flows through the resistor **5** is limited to about 0.002 mA when the compensating transistor **Q12** is in a conductive state. Thus, it the Iref is 1 mA, the current Ir is negligible with respect to the Iref. On the other hand, the relationship between the Ir, Ib12 and the base current Ib of the transistor **Q10** and **Q11** is expressed as follows:

${\text{h}}_{\text{FE}} \text{12·Ib12 + Ir = 2Ib (4)}$

thus,

${\text{Ib12 = (2Ib - Ir)/h}}_{\text{FE}} {\text{≃ 2Is/h}}_{\text{FE}} {\text{² - Ir/h}}_{\text{FE}} \text{(5)}$

wherein h_{FE}12 is the current gain ot the transistor **Q12**. As apparent from the equation (5), the base current of the transistor **Q12** is also very small. Thus, a current mirror circuit, having an improved current mirror ratio, and being operative at a relatively low power source voltage, is achieved.

In **FIG.5B**, **NPN** type transistors are used instead of the **PNP** transistors. Namely, in this circuit, the emitter electrodes of the **NPN** transistors **Q13** and **Q14** are connected to the **GND** terminal, and their base electrodes are connected in common. The collector electrode of the transistor **Q13** is connected to the power source terminal **Vcc** through an input current source **3**. The emitter electrode of the compensating transistor **Q15** is connected to the common connection of the base electrodes of the transistors **Q13** and **Q14**. The base electrode of the transistor **Q15** is connected to the collector electrode of the transistor **Q13**, and the collector electrode thereof is connected to the power source terminal **Vcc**.

This circuit operates in the same way as the circuit of **FIG.5A**. Namely, when the power source voltage Vcc is below VF, no transistor is in a conductive state. When Vcc exceeds VF of the transistor **Q13**, assuming that the voltage drop at the input current source **3** is negligible, a base current is supplied to the base electrodes of the transistors **Q13** and **Q14** through the resistor **7**. Thus, the transistors **Q13** and **Q14** change into a conductive state. When Vcc increases, and the voltage drop at the resistor **7** exceeds VF, the transistor **Q15** changes into a conductive state to compensate for the current mirror rate dispersion based on the base currents of the transistors **Q13** and **Q14**.

The **FIG.6** shows the characteristic of the current mirror circuit of **FIGS.5A** and **5B**. As shown in the diagram, the current mirror circuit of this invention is operative at a low power source voltage, namely VF. Furthermore, the compensating transistor operates when the power source voltage exceeds 2VF to compensate for the dispersion of the current mirror rate due to the base current. Thus the current mirror rate is improved.

**FIG.7** is a circuit diagram of an amplifier circuit which is provided with an improved current mirror circuit of this invention. In this circuit, the numeral **70** designates a differential amplifier section, and the numeral **80** designates a current mirror circuit. In this circuit, the current mirror circuit **80** functions as an output circuit of the amplifier circuit.

The differential amplifier section **70** includes a pair of **PNP** type input transistors **Q24** and **Q25**. The base electrodes of the transistors **Q24** and **Q25** are connected to the non-inverting input terminal (+) and the inverting input terminal (-), respectively. The emitter electrodes of the transistors **Q24** and **Q25** are connected to the power source terminal **Vcc** through a current source **10**. The collector electrode of the transistor **Q24** is connected to the **GND** terminal through a diode-connected transistor **Q27**. Namely, the collector electrode and the base electrode of the transistor **Q27** are connected in common, and are connected to the collector electrode of the transistor **Q24**. The emitter electrode of the transistor **Q27** is connected to the **GND** terminal. The collector electrode of the transistor **Q25** is connected to the **GND** terminal through a diode-connected transistor **Q28**. Namely, the base and the collector electrodes of the transistor **Q28** are connected in common, and are connected to the collector electrode of the transistor **Q25**. The emitter electrode of the transistor **Q26** is connected to the **GND** terminal, and the base electrode thereof is connected to the base electrode of the transistor **Q28** to form a current mirror circuit. The base electrode of a transistor **Q29** is connected to the **GND** terminal, and the base electrode thereof is connected to the base electrode of the transistor **Q27** to form a current mirror circuit. The geometric dimension of the transistor **Q29** is N times larger than that of the transistor **Q27**. Thus, the collector current of the transistor **Q29** is N times larger than that of the transistor **Q27**.

The numeral **80** designates an improved current mirror circuit of this invention. The current mirror circuit **80** includes **PNP** type transistors **Q21**, **Q22** and **Q23** and a resistor **5**. The emitter electrodes of the transistors **Q21** and **Q22** are connected to the power source terminal **Vcc**, and the base electrodes of the transistors **Q21** and **Q22** are connected in common. The geometric dimension of the emitter area of the transistor **Q22** is N times larger than that of the transistor **Q21**. Thus, the collector current of the transistor **Q22** is N times larger than that of the transistor **Q21**. The collector electrode of the transistor **Q21** is connected to the collector electrode of the transistor **Q26**. The collector electrode of the transistor **Q22** is connected to the output terminal **OUT** and the collector electrode of the transistor **Q29**.

In this circuit, when the potential at the inverting input terminal (-) is lower than that of the non-inverting input terminal (+), the transistors **Q25**, **Q28**, **Q26**, **Q21**, **Q22** and **Q23** change into the conductive state. Thus, an output current is supplied from the output terminal **OUT**. On the other hand, when the potential at the non-inverting input terminal (+) is lower than that of the inverting input terminal (-), the transistors **Q24**, **Q27** and **Q29** change into conductive state, to absorb an output current from the output terminal **OUT**.

As the improved current mirror circuit of this invention is operative at a relatively low power source voltage, about 0.9 (v), it is possible to provide an amplifier circuit which is operative at a low power source voltage. Furthermore, the common connection of the collector electrodes of the transistors **Q22** and **Q29** is connected to the output terminal **OUT**, and the dynamic range of the output voltage is wide. Namely, the maximum output voltage Vmax, and the minimum output voltage Vmin are expressed as follows:

$\text{Vmax = Vcc - Vces22 (6)}$

$\text{Vmin = Vces29 (7)}$

wherein Vces22 and Vces29 are the collector-emitter voltages of the transistors **Q22** and **Q29** at the saturation state. Since, this amplifier circuit is operative at a low power source voltage over a wide dynamic range, this circuit is preferable as an amplifier circuit in a speech network where a low power voltage operation is required, and where the input current depends on the power source voltage, such as a telephone circuit.

## Claims

1. A current mirror circuit comprising, first and second power source terminals (Vcc, GND), and first transistor means (Q10) for receiving an input current (Iref), having an emitter electrode, a base electrode and a collector electrode, and second transistor means (Q11) for outputting an output current, having an emitter electrode, a base electrode and a collector electrode, and means for connecting the emitter electrodes of said first and second transistor means to the first power source terminal, and means for supplying the input current to the collector electrode of the first transistor means. characterized by comprising:
resistor means (5) for connecting the base electrode of the first transistor means to the collector electrode thereof;
third transistor means (Q12) for supplying a predetermined current to the base electrodes of the first and second transistor means when the voltage drop across the resistor means exceeds a predetermined value.

2. A current mirror circuit of claim 1, wherein the first, the second and the third transistor means each include a PNP type transistor.

3. A current mirror circuit of claim 1, wherein the first, the second and the third transistor means each include an **NPN** type transistor.

4. A current mirror circuit of claim 1, wherein the second transistor means has a larger emitter area than that of the first transistor means.

5. An amplifier circuit for amplifying an input signal, and for outputting an amplified output signal, comprising:
first and second power source terminals (Vcc, GND);
input terminal means ((+). (-))for receiving the input signal;
output terminal means (OUT) for outputting the output signal;
transistor circuit means (70) for generating an input current responsive to the input signal; characterized by
a current mirror circuit (80) including;
first transistor means (Q21) for receiving the input current, having an emitter electrode, a base electrode and a collector electrode,
means for connecting the collector electrode of the first transistor means to the transistor circuit means,
second transistor means (Q22) having an emitter electrode, a base electrode and a collector electrode,
means for connecting the emitter electrodes of said first and second transistor means to the first power source terminal,
means for connecting the collector electrode of the second transistor means to the output terminal means,
resistor means (5) for connecting the base electrode of the first transistor means to the collector electrode thereof,
third transistor means (Q23) for supplying a predetermined current to the base electrodes of the first and second transistor means when the voltage drop across the resistor means exceeds a predetermined value.

6. An amplifier circuit of claim 5, wherein the input terminal means comprises first and second input terminals.

7. An amplifier circuit of claim 6, wherein the transistor circuit means comprises;
first and second input transistors (Q24, Q25) of a first conductivity type, each having an emitter electrode, a base electrode and a collector electrode;
means for connecting the base electrodes of the first and second input transistors to the first and second input terminals, respectively;
means for supplying a bias current to the emitter electrodes of the first and second input transistors;
a third transistor (Q27) of a second conductivity type. having a collector electrode connected to the collector electrode of the first input transistor, a base electrode connected to the collector electrode thereof, and an emitter electrode connected to the second power terminal;
a fourth transistor (Q28) of the second conductivity type, having a collector electrode connected to the collector electrode of the second input transistor, a base electrode connected to the collector electrode thereof, and an emitter electrode connected to the second power terminal;
a fifth transistor (Q26) of the second conductivity type, having a base electrode connected to the base electrode of the fourth transistor, an emitter electrode connected to the second power source electrode and a collector electrode connected to the collector electrode of the first transistor means;
a sixth transistor (Q29) of the second conductivity type, having a base electrode connected to the base electrode of the third transistor, an emitter electrode connected to the second power source terminal and a collector electrode connected to the collector electrode of the second transistor means.

## Patentansprüche

1. Stromspiegelschaltung, mit einer ersten und einer zweiten Stromquellen-Klemme (Vcc, GND), und einem ersten Transistormittel (Q10), um einen Eingangsstrom (Iref) zu empfangen, das eine Emitterelektrode, eine Basiselektrode, und eine Kollektorelektrode aufweist, und einem zweiten Transistormittel (Q11) um einen Ausgangsstrom auszusenden, das eine Emitterelektrode, eine Basiselektrode und eine Kollektorelektrode aufweist, und einem Mittel, um die Emitterelektroden des ersten und des zweiten Transistormittels mit der ersten Stromquellen-Klemme zu verbinden, und einem Mittel, um den Eingangsstrom nach der Kollektorelektrode des ersten Transistormittels fließen zu lassen, dadurch gekennzeichnet, daß sie aufweist:
ein Widerstandsmittel (5), um die Basiselektrode des ersten Transistormittels mit der Kollektorelektrode des ersten Transistormittels zu verbinden;
ein drittes Transistormittel (Q12), um einen vorgegebenen Strom nach der Basiselektrode des ersten und des zweiten Transistormittels fließen zu lassen, wenn der Spannungsabfall über dem Widerstandsmittel einen vorgegebenen Wert übersteigt.

2. Stromspiegelschaltung gemäß Anspruch 1, wobei das erste, das zweite, und das dritte Transistormittel je einen PNP-Transistor umfassen.

3. Stromspiegelschaltung gemäß Anspruch 1, wobei das erste, das zweite, und das dritte Transistormittel je einen NPN-Transistor umfassen.

4. Stromspiegelschaltung gemäß Anspruch 1, wobei das zweite Transistormittel eine größere Emitterfläche als das erste Transistormittel hat.

5. Verstärkerschaltung zum Verstärken eines Eingangssignals, und zum Aussenden eines verstärkten Ausgangssignals, die aufweist:
- eine erste und eine zweite Stromquellen-Klemme (Vcc, GND);
- ein Eingangsklemmen-Mittel ((+), (-)), um das Eingangssignal zu empfangen;
- ein Ausgangsklemmen-Mittel (OUT), um das Ausgangssignal auszusenden;
- ein Transistorschaltungs-Mittel (70), um entsprechend dem Eingangssignal einen Eingangsstrom zu erzeugen;
gekennzeichnet durch eine Stromspiegelschaltung (80), die umfaßt:
- ein erstes Transistormittel (Q21), um den Eingangsstrom zu empfangen, mit einer Emitterelektrode, einer Basiselektrode und einer Kollektorelektrode;
- ein Mittel, um die Kollektorelektrode des ersten Transistormittels mit dem Transistorschaltungs-Mittel zu verbinden;
- ein zweites Transistormittel (Q22), das eine Emitterelektrode, eine Basiselektrode und eine Kollektorelektrode aufweist;
- ein Mittel, um die Emitterelektrode des ersten und des zweiten Transistormittels mit der ersten Stromquellen-Klemme zu verbinden;
- ein Mittel, um die Kollektorelektrode des zweiten Transistormittels mit dem Ausgangsklemmen-Mittel zu verbinden;
- ein Widerstandsmittel (5), um die Basiselektrode des ersten Transistormittels mit der Kollektorelektrode des ersten Transistormittels zu verbinden;
- ein drittes Transistormittel (Q23), um einen vorgegebenen Strom nach der Basiselektrode des ersten und des zweiten Transistormittels fließen zu lassen, wenn der Spannungsabfall über dem Widerstandsmittel einen vorgegebenen Wert übersteigt.

6. Verstärkerschaltung gemäß Anspruch 5, wobei das Eingangsklemmen-Mittel eine erste und eine zweite Eingangsklemme aufweist.

7. Verstärkerschaltung gemäß Anspruch 6, wobei das Transistorschaltungs-Mittel aufweist:
- einen ersten und einen zweiten Eingangstransistor (Q24, Q25) eines ersten Leitungstyps, von denen jeder eine Emitterelektrode, eine Basiselektrode und eine Kollektorelektrode aufweist;
- ein Mittel, um die Basiselektrode des ersten und des zweiten Eingangstransistors mit der ersten bzw. der zweiten Eingangsklemme zu verbinden;
- ein Mittel, um einen Vorstrom nach der Emitterelektrode des ersten und des zweiten Eingangstransistors fließen zu lassen;
- einen dritten Transistor (Q27) eines zweiten Leitungstyps, mit einer Kollektorelektrode, die mit der Kollektorelektrode des ersten Eingangstransistors verbunden ist, einer Basiselektrode, die mit der Kollektorelektrode des dritten Transistors verbunden ist, und einer Emitterelektrode, die mit der zweiten Stromquellen-Klemme verbunden ist;
- einen vierten Transistor (Q28) des zweiten Leitungstyps, mit einer Kollektorelektrode, die mit der Kollektorelektrode des zweiten Eingangstransistors verbunden ist, einer Basiselektrode, die mit der Kollektorelektrode des vierten Transistors verbunden ist, und einer Emitterelektrode, die mit der zweiten Stromquellen-Klemme verbunden ist;
- einen fünften Transistor (Q26) des zweiten Leitungstyps, mit einer Basiselektrode, die mit der Basiselektrode des vierten Transistors verbunden ist, einer Emitterelektrode, die mit der zweiten Stromquellen-Elektrode verbunden ist, und einer Kollektorelektrode, die mit der Kollektorelektrode des ersten Transistormittels verbunden ist;
- einen sechsten Transistor (Q29) des zweiten Leitungstyps, mit einer Basiselektrode, die mit der Basiselektrode des dritten Transistors verbunden ist, einer Emitterelektrode, die mit der zweiten Stromquellen-Klemme verbunden ist, und einer Kollektorelektrode, die mit der Kollektorelektrode des zweiten Transistormittels verbunden ist.

## Revendications

1. Circuit miroir de courant comprenant des première et seconde bornes de source d'alimentation (Vcc, GND) et un premier moyen de transistor (Q10) pour recevoir un courant d'entrée (Iref), comportant une électrode d'émetteur, une électrode de base et une électrode de collecteur, et un second moyen de transistor (Q11) pour émettre en sortie un courant de sortie, comportant une électrode d'émetteur, une électrode de base et une électrode de collecteur, et un moyen pour connecter les électrodes d'émetteur desdits premier et second moyens de transistor à la première borne de source d'alimentation ainsi qu'un moyen pour appliquer le courant d'entrée à l'électrode de collecteur du premier moyen de transistor, caractérisé en ce qu'il comprend:
un moyen de résistance (5) pour connecter l'électrode de base du premier moyen de transistor à son électrode de collecteur; et
un troisième moyen de transistor (Q12) pour appliquer un courant prédéterminé aux électrodes de base des premier et second moyens de transistor lorsque la chute de tension aux bornes du moyen de résistance excède une valeur prédéterminée.

2. Circuit miroir de courant selon la revendication 1, dans lequel les premier, second et troisième moyens de transistor incluent chacun un transistor du type PNP.

3. Circuit miroir de courant selon la revendication 1, dans lequel les premier, second et troisième moyens de transistor incluent chacun un transistor du type NPN.

4. Circuit miroir de courant selon la revendication 1, dans lequel le second moyen de transistor comporte une zone d'émetteur plus importante que celle du premier moyen de transistor.

5. Circuit amplificateur pour amplifier un signal d'entrée et pour émettre en sortie un signal de sortie amplifié, comprenant:
des première et seconde bornes de source d'alimentation (Vcc, GND);
un moyen de borne d'entrée ((+), (-)) pour recevoir le signal d'entrée;
un moyen de borne de sortie (OUT) pour émettre en sortie le signal de sortie;
un moyen de circuit de transistor (70) pour générer un courant d'entrée en réponse au signal d'entrée, caractérisé par:
un circuit miroir de courant (80) incluant:
un premier moyen de transistor (Q21) pour recevoir le courant d'entrée, comportant une électrode d'émetteur, une électrode de base et une électrode de collecteur;
un moyen pour connecter l'électrode de collecteur du premier moyen de transistor au moyen de circuit de transistor;
un second moyen de transistor (Q22) comportant une électrode d'émetteur, une électrode de base et une électrode de collecteur;
un moyen pour connecter les électrodes d'émetteur desdits premier et second moyens de transistor à la première borne de source d'alimentation;
un moyen pour connecter l'électrode de collecteur du second moyen de transistor au moyen de borne de sortie;
un moyen de résistance (5) pour connecter l'électrode de base du premier moyen de transistor à son électrode de collecteur; et
un troisième moyen de transistor (Q23) pour appliquer un courant prédéterminé aux électrodes de base des premier et second moyens de transistor lorsque la chute de tension aux bornes du moyen de résistance excède une valeur prédéterminée.

6. Circuit amplificateur selon la revendication 5, dans lequel le moyen de borne d'entrée comprend des première et seconde bornes d'entrée.

7. Circuit d'amplificateur selon la revendication 6, dans lequel le moyen de circuit de transistor comprend:
des premier et second transistors d'entrée (Q24, Q25) d'un premier type de conductivité dont chacun comporte une électrode d'émetteur, une électrode de base et une électrode de collecteur;
un moyen pour connecter respectivement les électrodes de base des premier et second transistors d'entrée aux première et seconde bornes d'entrée;
un moyen pour appliquer un courant de polarisation aux électrodes d'émetteur des premier et second transistors d'entrée;
un troisième transistor (Q27) d'un second type de conductivité comportant une électrode de collecteur connectée à l'électrode de collecteur du premier transistor d'entrée, une électrode de base connectée à son électrode de collecteur et une électrode d'émetteur connectée à la seconde borne d'alimentation;
un quatrième transistor (Q28) du second type de conductivité comportant une électrode de collecteur connectée à l'électrode de collecteur du second transistor d'entrée, une électrode de base connectée à son électrode de collecteur et une électrode d'émetteur connectée à la seconde borne d'alimentation;
un cinquième transistor (Q26) du second type de conductivité comportant une électrode de base connectée à l'électrode de base du quatrième transistor, une électrode d'émetteur connectée à la seconde électrode de source d'alimentation et une électrode de collecteur connectée à l'électrode de collecteur du premier moyen de transistor; et
un sixième transistor (Q29) du second type de conductivité comportant une électrode de base connectée à l'électrode de base du troisième transistor, une électrode d'émetteur connectée à la seconde borne de source d'alimentation et une électrode de collecteur connectée à l'électrode de collecteur du second moyen de transistor.
